# EUROPEAN PATENT APPLICATION

(11) **EP 4 822 369 A1**
(43) Date of publication of application: **14.10.2026**
(21) Application number: 25170090.2
(22) Date of filing: 11.04.2025
(51) Int. Cl.: G01R 31/389, G01R 31/392, G01R 31/396

(54) **POWER PATH AND CELL FAULT DETECTION IN MULTI-PACK ELECTRICAL ENERGY STORAGE SYSTEMS**

(71) Applicant: Volvo Truck Corporation, 405 08 Göteborg (SE)
(72) Inventor: LILLMAA, Henri, 463 72 LÖDÖSE (SE); RAY, Dripta, 412 48 GÖTEBORG (SE)
(74) Representative: Kransell & Wennborg KB

(57) **Abstract**

A computer system (100) comprising processing circuitry (102) configured to: acquire internal resistance values (R_{cell}) of individual electrical energy storage cells within an electrical energy storage pack (104a-b), acquire an overall internal resistance (Rₒᵥₑᵣₐₗₗ) of the electrical energy storage pack including cell and power path resistances, associate each internal resistance value of individual cells and the overall internal resistance with other electrical energy storage pack characteristics (110), compare the internal resistance values of individual cells and the overall internal resistance with a cell internal resistance reference parameter (112) and an overall internal resistance reference parameter (114) for other electrical energy storage packs with similar electrical energy storage pack characteristics, the other electrical energy storage packs are within a fleet of units equipped with electrical energy storage packs, when either the acquired internal resistance value of a cell fulfil a cell resistance criterion, and/or the acquired overall internal resistance fulfil an overall resistance criterion, provide an output message (M) that a fault is detected in the respective cell (106) and/or electrical energy storage pack (104a-b) power path.

## Description

### TECHNICAL FIELD

The disclosure relates generally to electrical energy storage systems. In particular aspects, the disclosure relates to power path fault and cell fault detection in multi-pack electrical energy storage systems. The disclosure can be applied to heavy-duty vehicles, such as trucks, buses, and construction equipment, among other vehicle types such as passenger cars. Although the disclosure may be described with respect to a particular vehicle, the disclosure is not restricted to any particular vehicle. The disclosure may also be applied to industrial applications, marine vessels, and stationary applications.

### BACKGROUND

In high-voltage battery systems used in electric vehicles, energy storage fleets, and industrial applications, maintaining battery health and reliability is critical. Over time, battery cells experience degradation, leading to increased internal resistance, capacity fade, and potential failures. Additionally, faults in the power path, such as connection issues or contact degradation, can compromise system performance and safety. Existing battery management systems primarily monitor state of charge (SoC) and state of health (SoH) but lack precise methods to distinguish between cell degradation and power path faults across multi-pack and fleet-level applications.

### SUMMARY

According to a first aspect of the disclosure, there is provided a computer system comprising processing circuitry configured to: acquire internal resistance values of individual electrical energy storage cells within an electrical energy storage pack, acquire an overall internal resistance of the electrical energy storage pack including cell and power path resistances, associate each internal resistance value of individual cells and the overall internal resistance with other electrical energy storage pack characteristics, compare the internal resistance values of individual cells and the overall internal resistance with a cell internal resistance reference parameter and an overall internal resistance reference parameter for other electrical energy storage packs with similar electrical energy storage pack characteristics, the other electrical energy storage packs are within a fleet of units equipped with the electrical energy storage packs, when either the acquired internal resistance value of a cell fulfil a cell resistance criterion, and/or the acquired overall internal resistance fulfil an overall resistance criterion, provide an output message (M) that a fault is detected in the respective cell and/or electrical energy storage pack power path.

The first aspect of the disclosure may seek to provide a robust solution for detecting power path faults within an electrical energy storage pack such as faults in the HV bus-bars, contactors, fuse connections etc. Furthermore, the present disclosure provides for accurately detecting and differentiating between cell degradation and power path faults in electrical energy storage packs. Using reference data from other electrical energy storage packs of a fleet, improves the detection accuracy. For example, by comparing the internal resistance of a given electrical energy storage pack to similar packs operating under comparable conditions, anomalies can be detected more reliably. Instead of assuming a resistance increase is due to natural aging, the present disclosure suggests checking if similar packs with e.g., equivalent charge cycles and energy throughput show the same trend.

To fulfill a criterion may be to deviate from or exceed a threshold. For example, when either the acquired internal resistance value of a cell deviates from the reference cell internal resistance data by more than a cell resistance threshold, and/or the acquired overall internal resistance deviates from reference overall internal resistance data by more than an overall resistance threshold, provide an output message that a fault is detected in the respective cell and/or electrical energy storage pack power path.

Preferably, the unit is herein a vehicle although other units are envisaged such as stationary applications or marine vessels.

Optionally, in some examples, including in at least one preferred example, the cell internal resistance reference parameter and the overall internal resistance reference parameter are derived from reference cell internal resistance data and reference overall internal resistance data that are stored in a database comprising reference data for multiple electrical energy storage packs within a fleet of units using the electrical energy storage packs. A technical benefit may include enabling comparative fault detection by using fleet-wide historical data, allowing distinguishing between normal aging trends and abnormal faults. This advantageously increases accuracy in fault detection and may reduce unnecessary maintenance and premature pack replacements.

The cell internal resistance reference parameter and the overall internal resistance reference parameter may herein be referred to as reference data.

Optionally, in some examples, including in at least one preferred example, the processing circuitry is further configured to upload the acquired cell and pack internal resistance values to the database for use as future reference data. A technical benefit may include continuous improvement of fault detection accuracy by updating the fleet reference database. This allows for the fault detection criterion to evolve based on real-world data and trends. Thus, the reference data can be kept up to date and further provide for more accurate and reliable fault detections.

Optionally, in some examples, including in at least one preferred example, the electrical energy storage characteristics include at least one of capacity fade, energy throughput, average charge rate, average discharge rate, average temperature, state of charge data, and temperature histograms. A technical benefit may include that these electrical energy storage characteristics are closely related to the performance of the packs. By categorizing the reference data based on relevant pack characteristics, the fault detection precision can be improved.

Optionally, in some examples, including in at least one preferred example, the output message indicating a detected fault further includes a classification of the fault type, distinguishing between a cell degradation fault and a power path fault. A technical benefit may include faster and more targeted maintenance, as the computer system can pinpoint whether a failure originates from an individual cell or from power path components (e.g., busbars, connectors). This improves service efficiency and reduces diagnostic time for repair personnel.

Optionally, in some examples, including in at least one preferred example, the processing circuitry performs the fault detection in real-time during operation of the electrical energy storage pack and/or during scheduled diagnostic cycles. A technical benefit may include immediate fault detection and response, preventing sudden failures and safety hazards. By detecting faults in real-time, timely alerts can be provided, which allows users to take preventive action before severe degradation occurs.

Optionally, in some examples, including in at least one preferred example, the processing circuitry is further configured to provide the indication of the fault to an HMI in a vehicle cab. By displaying fault notifications directly on the human-machine interface (HMI), the driver may take prompt action, such as stopping the vehicle or seeking maintenance. Early warnings allow for preventive action before a fault escalates into a serious safety hazard.

Optionally, in some examples, including in at least one preferred example, the processing circuitry is further configured to disconnect the faulty electrical energy storage pack from a voltage bus. By disconnecting a failing pack, further degradation may be prevented, allowing service personnel to address the issue before it worsens, reducing repair costs. Furthermore, safety for occupants of the vehicle may be improved by reducing the risk of overheating. Still further, in some situations, isolating only the affected pack provides the ability that the vehicle can continue operating on the remaining healthy packs.

There is further provided a vehicle comprising the computer system. In such case, the "unit" is a vehicle.

According to a second aspect of the disclosure, there is provided a computer system comprising processing circuitry configured to: acquire internal resistance values of individual electrical energy storage cells within electrical energy storage packs in a fleet of units, acquire an overall internal resistance of the electrical energy storage packs in the fleet, associate each internal resistance value of individual cells and the overall internal resistance with other electrical energy storage pack characteristics, process the acquired internal resistance values and the acquired overall internal resistance values to determine a cell internal resistance reference parameter and an overall internal resistance reference parameter that reflect the typical internal resistance parameter values for a functional electrical energy storage pack of each of the other electrical energy storage pack characteristics, store the cell internal resistance reference parameter and an overall internal resistance reference parameter along with their associated electrical energy storage pack characteristics on a memory storage device, receive a request for cell internal resistance reference parameter and an overall internal resistance reference parameter from a first unit of the fleet, the request including at least one electrical energy storage pack characteristic, provide, to the first unit, reference data associated with the at least one electrical energy storage pack characteristic.

The second aspect of the disclosure may seek to generate and managing reference data based on internal resistance values and electrical energy storage pack characteristics across a fleet of units such as vehicles. This system enables vehicles to request and receive context-specific reference data for fault detection.

According to a third aspect of the disclosure, there is provided a computer-implemented method, comprising: acquiring, by processing circuitry of a computer system, internal resistance values of individual electrical energy storage cells within an electrical energy storage pack, acquiring, by the processing circuitry, an overall internal resistance of the electrical energy storage pack including cell and power path resistances, associating, by the processing circuitry, each internal resistance value of individual cells and the overall internal resistance with other electrical energy storage pack characteristics, comparing, by the processing circuitry, the internal resistance values of individual cells and the overall internal resistance with a cell internal resistance reference parameter and an overall internal resistance reference parameter for other electrical energy storage packs with similar electrical energy storage pack characteristics, the other electrical energy storage packs are within a fleet of units equipped with the electrical energy storage packs, when either the acquired internal resistance value of a cell fulfil a cell resistance criterion, and/or the acquired overall internal resistance fulfil an overall resistance criterion, providing, by the processing circuitry, an output message that a fault is detected in the respective cell and/or electrical energy storage pack power path.

The third aspect of the disclosure may seek to provide a robust solution for detecting power path faults within an electrical energy storage pack such as faults in the high-voltage (HV) bus-bars, contactors, fuse connections etc. Furthermore, the present disclosure provides for accurately detecting and differentiating between cell degradation and power path faults in electrical energy storage packs. By using reference data from other electrical energy storage packs of a fleet, improves the detection accuracy. For example, by comparing the internal resistance of a given electrical energy storage pack to similar packs operating under comparable conditions, anomalies can be detected more reliably. Instead of assuming a resistance increase is due to natural aging, the present disclosure suggests checking if similar packs with e.g., equivalent charge cycles and energy throughput show the same trend.

Optionally, in some examples, including in at least one preferred example, the cell internal resistance reference parameter and the overall internal resistance reference parameter are derived from reference data stored in a database comprising reference data for multiple electrical energy storage packs within a fleet of units. A technical benefit may include enabling comparative fault detection by using fleet-wide historical data, allowing distinguishing between normal aging trends and abnormal faults. This advantageously increases accuracy in fault detection and may reduce unnecessary maintenance and premature pack replacements.

Optionally, in some examples, including in at least one preferred example, the method further comprises uploading the acquired internal resistance values to the database for use as future reference data. A technical benefit may include continuous improvement of fault detection accuracy by updating the fleet-wide reference database. This allows for the fault detection criterion to evolve based on real-world data and trends. Thus, the reference data can be kept up to date and further provide for more accurate and reliable fault detections.

Optionally, in some examples, including in at least one preferred example, the electrical energy storage characteristics include at least one of capacity fade (SoQ or SoHq), energy throughput, average charge rate, average discharge rate, average temperature, state of charge data, and temperature histograms. A technical benefit may include that these electrical energy storage characteristics are closely related to the performance of the packs and are relatively straight-forward to detect or measure. By refining the reference data based on relevant pack characteristics, the fault detection precision can be improved.

Optionally, in some examples, including in at least one preferred example, the output message indicating a detected fault further includes a classification of the fault type, distinguishing between a cell degradation fault and a power path fault. A technical benefit may include faster and more targeted maintenance, as the system can pinpoint whether a failure originates from an individual cell or from power path components (e.g., busbars, connectors). This improves service efficiency and reduces diagnostic time for repair personnel.

Optionally, in some examples, including in at least one preferred example, the method is performed in real-time during operation of the electrical energy storage pack and/or during scheduled diagnostic cycles. A technical benefit may include immediate fault detection and response, preventing sudden failures and safety hazards. By detecting faults in real-time, timely alerts can be provided, which allows users to take preventive action before severe degradation occurs.

Optionally, in some examples, including in at least one preferred example, the method further comprises providing the indication of the fault to an HMI in a vehicle cab. By displaying fault notifications directly on the HMI, the driver may take prompt action, such as stopping the vehicle or seeking maintenance. Early warnings allow for preventive action before a fault escalates into a serious safety hazard.

Optionally, in some examples, including in at least one preferred example, the method further comprises disconnecting the faulty electrical energy storage pack from a voltage bus. By disconnecting a failing pack, further degradation may be prevented, allowing service personnel to address the issue before it worsens, reducing repair costs. Furthermore, safety for occupants of the vehicle may be improved by reducing the risk of overheating. Further, in some situations, isolating only the affected pack provides the ability that the vehicle can continue operating on the remaining healthy packs.

Optionally, in some examples, including in at least one preferred example, the method is performed by the processing circuitry on-board a vehicle comprising the electrical energy storage pack. A technical benefit may include real-time fault detection and response directly within the vehicle. This may ensure immediate fault handling and may enhance safety for occupants and reliability of the vehicle.

There is further provided a computer program product comprising program code for performing, when executed by the processing circuitry, the method of any of the third aspect.

There is further provided a non-transitory computer-readable storage medium comprising instructions, which when executed by the processing circuitry, cause the processing circuitry to perform the method of any of the third aspect.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

**FIG. 1** is an exemplary system diagram of a computer system according to an example.
**FIG. 2** is an exemplary system diagram of a computer system according to an example.
**FIG. 3** is a flow chart of an exemplary method according to an example.
**FIG. 4** is another view of **FIG. 1****,** according to an example.
**FIG. 5** is a flow chart of an exemplary method according to an example.
**FIG. 6** is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

High-voltage battery systems in electric vehicles, energy storage applications, and industrial fleets are prone to performance degradation over time due to factors such as aging, thermal stress, and varying operating conditions. Traditional battery monitoring systems primarily focus on state of charge (SoC) and state of health (SoH) but lack the ability to precisely track internal resistance changes across individual cells and power paths to pinpoint whether the fault originates from cell rapid degradation or from a power path failure.

Advantages of knowing whether the fault is from the cell rapid internal resistance growth or from the power path fault include that the information can be made available for both service personnel for faster repair as well as for a quality department provide distinct data for root cause analysis.

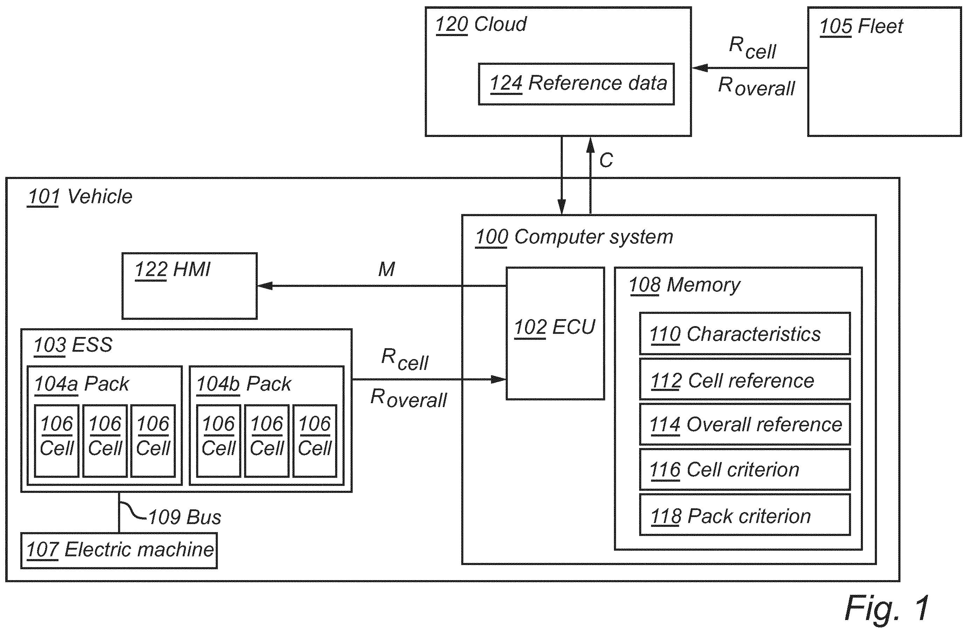

**FIG. 1** is an exemplary computer system 100 according to an example. The computer system is preferably comprised in a vehicle, here denoted a first vehicle 101. The vehicle 101 may be a heavy-duty vehicle such as a truck although the disclosure is not limited to any particular vehicle type.

The computer system 100 comprises a processing circuitry 102, such as an electric control unit (ECU), and a digital data storage memory 108. The processing circuitry 102 may store data in the memory 108 and retrieve data from the memory 108.

The vehicle 101, which is part of a fleet 105 of vehicles, comprises an electrical energy storage system 103 (ESS) comprising multiple electrical energy storage packs 104a-b. The electrical energy storage system 103 is configured to provide electrical power to an electric machine 107 via a voltage bus 109. That is, the electrical energy storage packs 104a-b, are electrically connected to the voltage bus 109 to provide electrical power, via the voltage bus 109, to the electric machine 107. The electrical energy storage packs 104a-b are individually connectable and disconnectable to the voltage bus. In other words, the processing circuitry 102 can control switches between the electrical energy storage packs 104a-b and the voltage bus 109 to connect and disconnect individual electrical energy storage packs 104a-b to/from the voltage bus 109. Preferably, the vehicle 101 is a multi-pack 104a-b electrical vehicle 101. This allows comparable analysis between packs of the vehicle in addition to the packs of the fleet 105.

The electrical energy storage packs 104a-b include a plurality of electrical energy storage cells 106 electrically connected in series and/or parallel. The cells 106 are based on a suitable technology such as Li-Ion technology although other technologies are also envisaged.

The processing circuitry 102 is configured to acquire internal resistance values (R_{cell}) of individual electrical energy storage cells within the electrical energy storage pack (104).

Furthermore, the processing circuitry 102 is configured to acquire an overall internal resistance (Rₒᵥₑᵣₐₗₗ) of e.g. the electrical energy storage pack 104a, or both packs 104a-b. The overall internal resistance, Rₒᵥₑᵣₐₗₗ, includes both cell and power path resistances. The power path is preferably power paths within the electrical energy storage pack 104. In some examples, the power path may include the path which connect the larger modules consisting of small cells, contactors, fuse, and also busbars, contactors, fuse connections, etc, from the pack 104a to the electric machine 107.

The internal resistance can be determined in various ways such as using estimation methods including Kalman filtering and machine learning on operating conditions and historical data, or by using measurement methods including applying a current pulse to the electrical energy storage pack or cell and analyzing the voltage drop before and after the pulse and then using the well-known Ohm's law. Typically, internal resistance can be provided by an ESS management unit of the vehicle.

The processing circuitry 102 thus acquires data of internal resistance on cell level and on pack level.

The processing circuitry 102 is configured to associate each internal resistance value (R_{cell}) of individual cells and the overall internal resistance (Rₒᵥₑᵣₐₗₗ) with other electrical energy storage pack characteristics 110. Data of electrical energy storage pack characteristics 110 is stored in the memory 108.

The electrical energy storage characteristics 110 may include at least one of capacity fade (e.g., SoQ or SoHq), energy throughput, average charge rate, average discharge rate, average temperature, state of charge data, temperature histograms. Capacity fade is a measure of how much the capacity of the cell or pack has dropped from its original capacity. Temperature histograms may be created by logging the temperatures within the electrical energy storage pack 104 over a lifetime: for example time spent in temperatures below -25 degC; between -25 degC and -10 degC; between -10 degC and 0 degC; between 0 degC and 10 degC; between 10 degC and 20 degC; between 20 degC and 45 degC; between 45 degC and 65 degC; above 65 degC. Then this usage history could give insight into degradation difference among electrical energy storage packs used in cold temperatures versus electrical energy storage packs used in 10.....45 degC range versus electric energy storage packs 104a-b used in hot temperatures.

Cell and pack state of charge in histograms similar to the temperature above are also envisaged for electrical energy storage characteristics 110.

Cell SoC over its lifetime could also be used as electrical energy storage characteristics 110, this means for how long time over its lifetime has a cell been at certain voltage or SoC, which also impacts the cell degradation.

Energy throughput may be the energy that has been charged and discharged during the entire life of the electrical energy storage pack.

Each of the electrical energy storage characteristics 110 can be determined on cell level and on pack level. The electrical energy storage characteristics 110 are historical data that reflect the usage and performance of the cell and pack over time. The electrical energy storage characteristics 110 are used to find a best fit reference data for the electrical energy storage pack 104.

The processing circuitry 102 is configured to compare the internal resistance values (R_{cell}) of individual cells 106 and the overall internal resistance values (Rₒᵥₑᵣₐₗₗ) with a cell internal resistance reference parameter 112 and an overall internal resistance reference parameter 114 for other electrical energy storage packs with similar electrical energy storage pack characteristics. The cell internal resistance reference parameter 112 and the overall internal resistance reference parameter 114 are stored in the memory 108. The other electrical energy storage packs from which the references 112 and 114 are determined are within the fleet 105 of units equipped with the electrical energy storage packs, the units here being electrified vehicles.

The reference data 124 from packs and cells from units of the fleet 105 is stored in a cloud-based database 120, e.g., on a server. The computer system 100 may periodically acquire updated references 112 and 114 based on the present characteristics 110 of the electrical energy storage packs 104a-b. Thus, the processing circuitry 102 may request C, from the server 120, a new cell reference 112 and a new pack reference 114 based on submitted updated electrical energy storage characteristics 110.

Logging of both internal resistance values (R_{cell}) of individual cells and the overall internal resistance values (R_{coverall}) of the packs 104a-b is performed periodically in the vehicle 101 and other vehicles of the fleet 105. The logged data is uploaded to the offline database 120, where the data is processed to establish reference parameter values and optionally also thresholds for given electrical energy storage characteristics 110, per vehicle type and per electrical energy storage pack type/model, vehicle application use case, etc.

Furthermore, the electrical energy storage characteristics 110, such as energy throughput, capacity fade, temperatures, charge and discharge rates, SoC, are also logged in the database as part of the reference data 124. It is then possible to establish expected internal resistance reference values, on both cell (reference 112) and pack level (reference 114), for e.g., a given energy throughput with given average temperature, or temperature distribution over lifetime in case of histogram data collection and storage, average SoC or SoC distribution over lifetime. Also because of the reference data 124 is vehicle fleet based, then a distribution of internal resistance reference values, both healthy and non-healthy, can be established, which contributes to designing/establishing reference values and thresholds to be used in the vehicle 101.

Thus, the cell internal resistance reference parameter 112 and the overall internal resistance reference parameter 114 are derived from reference cell and overall internal resistance data 124 that are stored in the database 120 for multiple electrical energy storage packs within the fleet 105 of devices or vehicles using the electrical energy storage packs.

The processing circuitry 102 is configured to, when either the acquired internal resistance value of a cell fulfil a cell resistance criterion 116, and/or the acquired overall internal resistance fulfil an overall resistance criterion 118, provide an output message M that a fault is detected in the respective cell and/or electrical energy storage pack power path.

That is, the processing circuitry 102 may process the acquired cell internal resistance value (R_{cell}) and the acquired overall internal resistance value (Rₒᵥₑᵣₐₗₗ) in view of the criteria, and once the criteria are fulfilled, the output message M is provided.

The criteria may be realized in different ways. For example, the criteria may be threshold. In such case, the evaluation may be to determine whether the acquired cell internal resistance value and the acquired overall internal resistance value is equal to or exceed a respective threshold.

As a further example, an interval of expected internal resistances may be created in the cloud 120 and be used as a criterion. That is the criterion may be internal resistances that are expected for a pack with a given energy throughput, SoH, etc. If the acquired internal cell resistance value (R_{cell}) and the acquired overall internal resistance value (Rₒᵥₑᵣₐₗₗ) is outside the respective interval, a fault may be considered detected.

With enough logged data 124 from the fleet 105, a distribution of internal resistance values on cell and pack level can be established from which outliers from the distribution range can be classified as belonging to a faulty electrical energy storage pack or cell.

Purely as an example, in the database 120 the average values can be considered when determining the cell and pack references, but it is also possible to weigh in the energy storage system maximum / minimum values over the lifetime. For example, if the average temperature over the lifetime of a first battery pack is 25 degC and the maximum temperature over lifetime is 60degC (preferably, a histogram logged data from the vehicle is used) then the cell degradation of the first electrical energy storage pack probably has different characteristics compared to a second electrical energy storage pack which also has had 25degC average lifetime temperature, but maximum temperature of 45degC.

In some examples, the output message indicates further includes a classification of the fault type, distinguishing between a cell degradation fault and a power path fault.

Preferably, the processing circuitry 102 performs the fault detection in real-time during operation of the electrical energy storage pack 104 and/or during scheduled diagnostic cycles. Thus, the fault detection procedure may be made in a vehicle while travelling.

The indication M of the fault may be provided to a human-machine-interface 122 (HMI) in a vehicle cab. The HMI 122 may be for example a display or a speaker.

Furthermore, the processing circuitry 102 may be further configured to upload the acquired internal resistance values to the database for use as future reference data. The vehicle 101 thus comprises suitable communication technology such as WiFi, telecommunication, V2X, that allows data exchange with the server 120.

In case a faulty electrical energy storage pack 104 is detected, the processing circuitry 102 may be further configured to disconnect the faulty electrical energy storage pack from the voltage bus 109.

That the vehicle 101 is a multi-pack vehicle advantageously provides for analyzing single electrical energy storage parameter deviation against the parameters of other electrical energy storage pack within the vehicle as well as with reference values 112, 114 from the fleet -- one of such parameters could be internal resistance. However, pack-to-pack SoC delta or pack-to-pack current delta assumes that the vehicle has multiple electrical energy storage packs among which the delta SoC or electrical current difference between packs can occur.

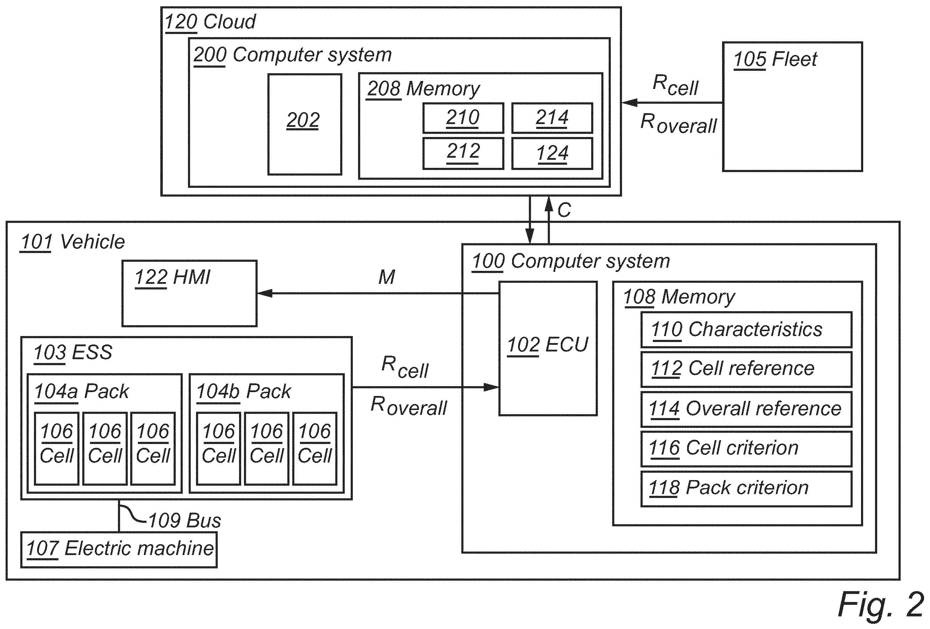

**FIG. 2** illustrates another aspect of the disclosure, including a computer system 200 preferably located on the server 120 remote from the first vehicle 101. The computer system 200 comprising processing circuitry 202 configured to: acquire internal resistance values (R_{cell}) of individual electrical energy storage cells within electrical energy storage packs 104a-b in a fleet of units, acquire an overall internal resistance (Rₒᵥₑᵣₐₗₗ) of the electrical energy storage packs in the fleet 105, associate each internal resistance value of individual cells and the overall internal resistance with other electrical energy storage pack characteristics 210 in the fleet 105, process the acquired internal cell resistance values (R_{cell}) and the acquired overall internal resistance values (Rₒᵥₑᵣₐₗₗ) to determine a cell internal resistance reference parameter 212 and an overall internal resistance reference parameter 214 that reflect the typical internal resistance parameter values for a functional electrical energy storage pack of each of the electrical energy storage pack characteristics 210, store the cell internal resistance reference parameter 212 and an overall internal resistance reference parameter 214 along with their associated electrical energy storage pack characteristics 210 on a memory storage device 208, receive a request, C, for cell internal resistance reference parameter and an overall internal resistance reference parameter from a first unit 101 of the fleet 105, the request including at least one electrical energy storage pack characteristic 110, provide, to the first unit, reference data 112, 114 associated with the at least one electrical energy storage pack characteristic.

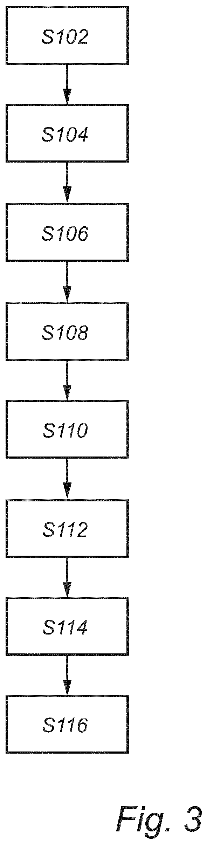

**FIG. 3** is a flow chart of a method for fault detection in an electrical energy storage pack 104a according to an example.

In step S102, acquiring, by processing circuitry 102 of a computer system 100, internal resistance values (R_{cell}) of individual electrical energy storage cells 106 within an electrical energy storage pack 104a among multiple packs 104a-b.

In step S104, acquiring, by the processing circuitry 102, an overall internal resistance (Rₒᵥₑᵣₐₗₗ) of the electrical energy storage pack 104a/104b including cell and power path resistances.

In step S106 associating, by the processing circuitry 102, each internal resistance value (R_{cell}) of individual cells and the overall internal resistance (Rₒᵥₑᵣₐₗₗ) with other electrical energy storage pack characteristics 110. The electrical energy storage characteristics 110 include at least one of capacity fade (SoQ or SoHq), energy throughput, average charge rate, average discharge rate, average temperature, state of charge data, temperature histograms.

In step S108, comparing, by the processing circuitry 102, the internal resistance values of individual cells and the overall internal resistance with a cell internal resistance reference parameter 112 and an overall internal resistance reference parameter 114 for other electrical energy storage packs with similar electrical energy storage pack characteristics 110, the other electrical energy storage packs are within a fleet 105 of units equipped with electrical energy storage packs. The cell internal resistance reference parameter 112 and the overall internal resistance reference parameter 114 may be derived from reference cell internal resistance data 124 and reference overall internal resistance data 124 that are stored in a database 120 comprising reference data 124 for multiple electrical energy storage packs within the fleet 105 of devices or vehicles using the electrical energy storage packs.

When either the acquired internal resistance value of a cell fulfil a cell resistance criterion 116, and/or the acquired overall internal resistance fulfil an overall resistance criterion 118, providing in step S110, by the processing circuitry 102, an output message M that a fault is detected in the respective cell and/or electrical energy storage pack power path.

Optionally, providing in step S112, by the processing circuitry 102, the indication of the fault to an HMI 122 in a vehicle cab.

Optionally, in step S114, uploading, by the processing circuitry 102, the acquired internal resistance values R_{cell} and Rₒᵥₑᵣₐₗₗ to the database 120 for use as future reference data.

Optionally, in step S116, disconnecting, by the processing circuitry 102, the faulty electrical energy storage pack from a voltage bus 109.

The steps S102-S116 shown in fig. 3 may be performed in real-time during operation of the electrical energy storage pack and/or during scheduled diagnostic cycles.

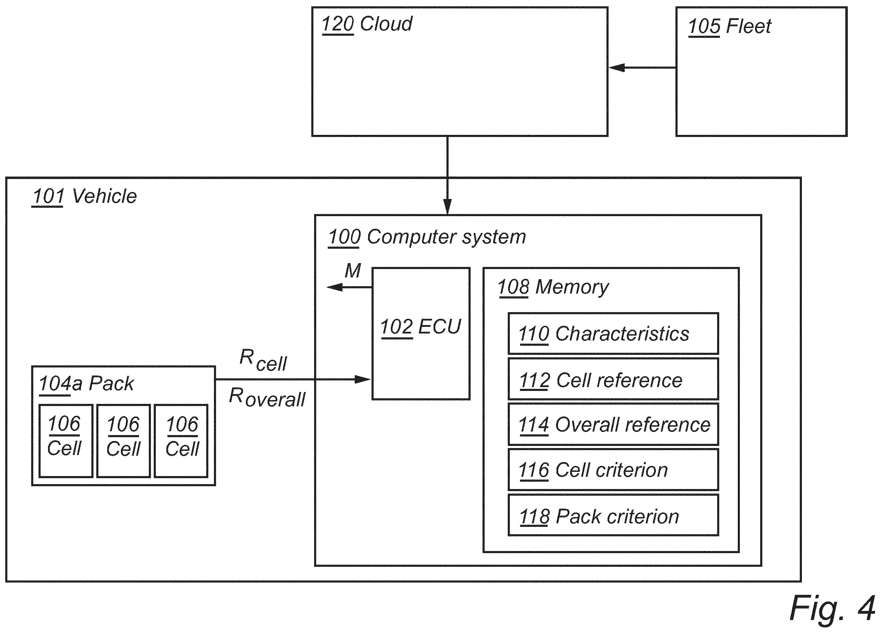

**FIG. 4** is another view of **FIG. 1****,** according to an example. A computer system 100 comprising processing circuitry 102 configured to: acquire internal resistance values (R_{cell}) of individual electrical energy storage cells 106 within an electrical energy storage pack 104a, acquire an overall internal resistance (Rₒᵥₑᵣₐₗₗ) of the electrical energy storage pack 104a including cell and power path resistances, associate each internal resistance value of individual cells and the overall internal resistance with other electrical energy storage pack characteristics 110, compare the internal resistance values of individual cells 106 and the overall internal resistance with a cell internal resistance reference parameter 112 and an overall internal resistance reference parameter 114 for other electrical energy storage packs with similar electrical energy storage pack characteristics, the other electrical energy storage packs are within a fleet 105 of units equipped with the electrical energy storage packs, when either the acquired internal resistance value of a cell fulfil a cell resistance criterion 116, and/or the acquired overall internal resistance fulfil an overall internal resistance criterion 118, provide an output message M that a fault is detected in the respective cell and/or electrical energy storage pack power path.

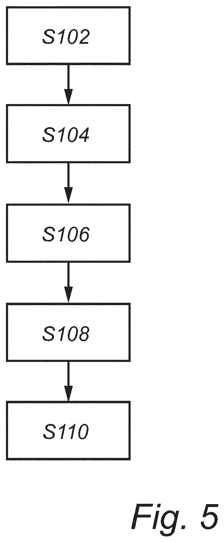

**FIG. 5** is a flow chart of a method according to an example.

In step S102, acquiring, by processing circuitry of a computer system, internal resistance values of individual electrical energy storage cells within an electrical energy storage pack.

In step S104, acquiring, by the processing circuitry, an overall internal resistance of the electrical energy storage pack including cell and power path resistances.

In step S106, associating, by the processing circuitry, each internal resistance value of individual cells and the overall internal resistance with other electrical energy storage pack characteristics.

In step S108, comparing, by the processing circuitry, the internal resistance values of individual cells and the overall internal resistance with a cell internal resistance reference parameter and an overall internal resistance reference parameter for other electrical energy storage packs with similar electrical energy storage pack characteristics, the other electrical energy storage packs are within a fleet of units equipped with the electrical energy storage packs.

When either the acquired internal resistance value of a cell fulfil a cell resistance criterion, and/or the acquired overall internal resistance fulfil an overall resistance criterion, providing in step S110, by the processing circuitry, an output message that a fault is detected in the respective cell and/or electrical energy storage pack power path.

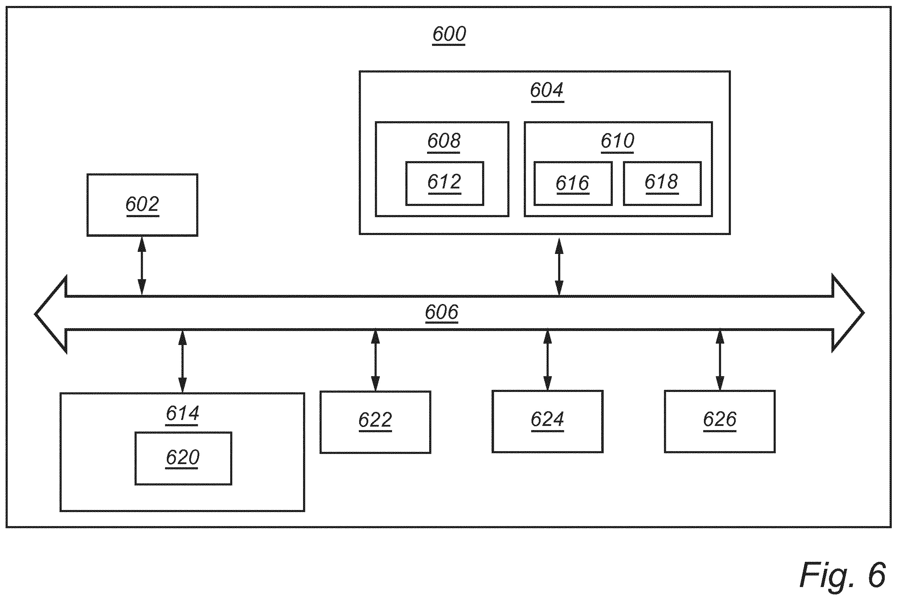

**FIG. 6** is a schematic diagram of a computer system **600** for implementing examples disclosed herein. The computer system **600** is adapted to execute instructions from a computer-readable medium to perform these and/or any of the functions or processing described herein. The computer system **600** may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system **600** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **600** may comprise at least one computing device or electronic device capable of including firmware, hardware, and/or executing software instructions to implement the functionality described herein. The computer system **600** may include processing circuitry **602** (e.g., processing circuitry including one or more processor devices or control units), a memory **604,** and a system bus **606.** The computer system **600** may include at least one computing device having the processing circuitry **602.** The system bus **606** provides an interface for system components including, but not limited to, the memory **604** and the processing circuitry **602.** The processing circuitry **602** may include any number of hardware components for conducting data or signal processing or for executing computer code stored in memory **604.** The processing circuitry **602** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **602** may further include computer executable code that controls operation of the programmable device.

The system bus **606** may be any of several types of bus structures that may further interconnect to a memory bus (with or without a memory controller), a peripheral bus, and/or a local bus using any of a variety of bus architectures. The memory **604** may be one or more devices for storing data and/or computer code for completing or facilitating methods described herein. The memory **604** may include database components, object code components, script components, or other types of information structure for supporting the various activities herein. Any distributed or local memory device may be utilized with the systems and methods of this description. The memory **604** may be communicably connected to the processing circuitry **602** (e.g., via a circuit or any other wired, wireless, or network connection) and may include computer code for executing one or more processes described herein. The memory **604** may include non-volatile memory **608** (e.g., read-only memory (ROM), erasable programmable read-only memory (EPROM), electrically erasable programmable read-only memory (EEPROM), etc.), and volatile memory **610** (e.g., random-access memory (RAM)), or any other medium which can be used to carry or store desired program code in the form of machine-executable instructions or data structures and which can be accessed by a computer or other machine with processing circuitry **602.** A basic input/output system (BIOS) **612** may be stored in the non-volatile memory **608** and can include the basic routines that help to transfer information between elements within the computer system **600.**

The computer system **600** may further include or be coupled to a non-transitory computer-readable storage medium such as the storage device **614,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **614** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **614** and/or in the volatile memory **610,** which may include an operating system **616** and/or one or more program modules **618.** All or a portion of the examples disclosed herein may be implemented as a computer program **620** stored on a transitory or non-transitory computer-usable or computer-readable storage medium (e.g., single medium or multiple media), such as the storage device **614,** which includes complex programming instructions (e.g., complex computer-readable program code) to cause the processing circuitry **602** to carry out actions described herein. Thus, the computer-readable program code of the computer program **620** can comprise software instructions for implementing the functionality of the examples described herein when executed by the processing circuitry **602.** In some examples, the storage device **614** may be a computer program product (e.g., readable storage medium) storing the computer program **620** thereon, where at least a portion of a computer program **620** may be loadable (e.g., into a processor) for implementing the functionality of the examples described herein when executed by the processing circuitry **602.** The processing circuitry **602** may serve as a controller or control system for the computer system **600** that is to implement the functionality described herein.

The computer system **600** may include an input device interface **622** configured to receive input and selections to be communicated to the computer system **600** when executing instructions, such as from a keyboard, mouse, touch-sensitive surface, etc. Such input devices may be connected to the processing circuitry **602** through the input device interface **622** coupled to the system bus **606** but can be connected through other interfaces, such as a parallel port, an Institute of Electrical and Electronic Engineers (IEEE) 1394 serial port, a Universal Serial Bus (USB) port, an IR interface, and the like. The computer system **600** may include an output device interface **624** configured to forward output, such as to a display, a video display unit (e.g., a liquid crystal display (LCD) or a cathode ray tube (CRT)). The computer system **600** may include a communications interface **626** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Example 1: A computer system comprising processing circuitry configured to: acquire internal resistance values of individual electrical energy storage cells within an electrical energy storage pack, acquire an overall internal resistance of the electrical energy storage pack including cell and power path resistances, associate each internal resistance value of individual cells and the overall internal resistance with other electrical energy storage pack characteristics, compare the internal resistance values of individual cells and the overall internal resistance with a cell internal resistance reference parameter and an overall internal resistance reference parameter for other electrical energy storage packs with similar electrical energy storage pack characteristics, the other electrical energy storage packs are within a fleet of units equipped with the electrical energy storage packs, when either the acquired internal resistance value of a cell fulfil a cell resistance criterion, and/or the acquired overall internal resistance fulfil an overall resistance criterion, provide an output message that a fault is detected in the respective cell and/or electrical energy storage pack power path.

Example 2: The computer system of example 1, wherein the cell internal resistance reference parameter and the overall internal resistance reference parameter are derived from reference cell internal resistance data and reference overall internal resistance data that are stored in a database comprising reference data for multiple electrical energy storage packs within a fleet of devices or vehicles using the electrical energy storage packs.

Example 3. The computer system of example 2, wherein the processing circuitry is further configured to: upload the acquired internal resistance values to the database for use as future reference data.

Example 4: The computer system of any of examples 1-3, wherein the electrical energy storage characteristics include at least one of capacity fade (SoQ or SoHq), energy throughput, average charge rate, average discharge rate, average temperature, state of charge data, temperature histograms.

Example 5: The computer system of any of examples 1-4, wherein the output message indicating a detected fault further includes a classification of the fault type, distinguishing between a cell degradation fault and a power path fault.

Example 6: The computer system of any of examples 1-5, wherein the processing circuitry performs the fault detection real-time during operation of the electrical energy storage pack and/or during scheduled diagnostic cycles.

Example 7: The computer system of any of examples 1-6, wherein the processing circuitry is further configured to: provide the indication of the fault to an HMI in a vehicle cab.

Example 8: The computer system of any of examples 1-7, wherein the processing circuitry is further configured to: disconnect the faulty electrical energy storage pack from a voltage bus.

Example 9: A vehicle comprising the computer system of any of examples 1-8.

Example 10: A computer system comprising processing circuitry configured to: acquire internal resistance values of individual electrical energy storage cells within electrical energy storage packs in a fleet of units, acquire an overall internal resistance of the electrical energy storage packs in the fleet, associate each internal resistance value of individual cells and the overall internal resistance with other electrical energy storage pack characteristics, process the acquired internal resistance values and the acquired overall internal resistance values to determine a cell internal resistance reference parameter and an overall internal resistance reference parameter that reflect the typical internal resistance parameter values for a functional electrical energy storage pack of each of the other electrical energy storage pack characteristics, store the cell internal resistance reference parameter and an overall internal resistance reference parameter along with their associated electrical energy storage pack characteristics on a memory storage device, receive a request for cell internal resistance reference parameter and an overall internal resistance reference parameter from a first unit of the fleet, the request including at least one electrical energy storage pack characteristic, provide, to the first unit, reference data associated with the at least one electrical energy storage pack characteristic.

Example 11: A computer-implemented method, comprising: acquiring, by processing circuitry of a computer system, internal resistance values of individual electrical energy storage cells within an electrical energy storage pack, acquiring, by the processing circuitry, an overall internal resistance of the electrical energy storage pack including cell and power path resistances, associating, by the processing circuitry, each internal resistance value of individual cells and the overall internal resistance with other electrical energy storage pack characteristics, comparing, by the processing circuitry, the internal resistance values of individual cells and the overall internal resistance with a cell internal resistance reference parameter and an overall internal resistance reference parameter for other electrical energy storage packs with similar electrical energy storage pack characteristics, the other electrical energy storage packs are within a fleet of units equipped with the electrical energy storage packs, when either the acquired internal resistance value of a cell fulfil a cell resistance criterion, and/or the acquired overall internal resistance fulfil an overall resistance criterion, providing, by the processing circuitry, an output message that a fault is detected in the respective cell and/or electrical energy storage pack power path.

Example 12: The method of example 11, wherein the cell internal resistance reference parameter and the overall internal resistance reference parameter are derived from reference cell internal resistance data and reference overall internal resistance data that are stored in a database comprising reference data for multiple electrical energy storage packs within a fleet of devices or vehicles using the electrical energy storage packs.

Example 13: The method of example 12, further comprising: uploading, by the processing circuitry, the acquired internal resistance values to the database for use as future reference data.

Example 14: The method of any of examples 11-13, wherein the electrical energy storage characteristics include at least one of capacity fade (SoQ or SoHq), energy throughput, average charge rate, average discharge rate, average temperature, state of charge data, temperature histograms.

Example 15: The method of any of examples 11-14, wherein the output message indicating a detected fault further includes a classification of the fault type, distinguishing between a cell degradation fault and a power path fault.

Example 16: The method of any of examples 11-15, wherein the method is performed in real-time during operation of the electrical energy storage pack and/or during scheduled diagnostic cycles.

Example 17: The method of any of examples 11-16, further comprising: providing, by the processing circuitry, the indication of the fault to an HMI in a vehicle cab.

Example 18: The method of any of examples 11-17, further comprising: disconnecting, by the processing circuitry, the faulty electrical energy storage pack from a voltage bus.

Example 19: The method of any of examples 11-18, performed by the processing circuitry on-board a vehicle comprising the electrical energy storage pack.

Example 20: A computer program product comprising program code for performing, when executed by the processing circuitry, the method of any of examples 11-19.

Example 21: A non-transitory computer-readable storage medium comprising instructions, which when executed by the processing circuitry, cause the processing circuitry to perform the method of any of examples 11-19.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system (100) comprising processing circuitry (102) configured to:
acquire internal resistance values (R_{cell}) of individual electrical energy storage cells within an electrical energy storage pack (104a-b),
acquire an overall internal resistance (Rₒᵥₑᵣₐₗₗ) of the electrical energy storage pack including cell and power path resistances,
associate each internal resistance value of individual cells and the overall internal resistance with other electrical energy storage pack characteristics (110),
compare the internal resistance values of individual cells and the overall internal resistance with a cell internal resistance reference parameter (112) and an overall internal resistance reference parameter (114) for other electrical energy storage packs with similar electrical energy storage pack characteristics, the other electrical energy storage packs are within a fleet of units equipped with electrical energy storage packs,
when either the acquired internal resistance value of a cell fulfil a cell resistance criterion, and/or the acquired overall internal resistance fulfil an overall resistance criterion, provide an output message (M) that a fault is detected in the respective cell (106) and/or electrical energy storage pack (104a-b) power path.

2. The computer system of claim 1, wherein the cell internal resistance reference parameter and the overall internal resistance reference parameter are derived from reference cell internal resistance data and reference overall internal resistance data that are stored in a database (120) comprising reference data (120) for multiple electrical energy storage packs within a fleet of devices or vehicles using electrical energy storage packs.

3. The computer system of claim 2, wherein the processing circuitry is further configured to:
upload the acquired internal resistance values to the database for use as future reference data.

4. The computer system of any of claims 1-3, wherein the electrical energy storage characteristics include at least one of capacity fade (SoQ or SoHq), energy throughput, average charge rate, average discharge rate, average temperature, state of charge data, temperature histograms.

5. The computer system of any of claims 1-4, wherein the output message indicating a detected fault further includes a classification of the fault type, distinguishing between a cell degradation fault and a power path fault.

6. The computer system of any of claims 1-5, wherein the processing circuitry performs the fault detection real-time during operation of the electrical energy storage pack and/or during scheduled diagnostic cycles.

7. The computer system of any of claims 1-6, wherein the processing circuitry is further configured to:
provide the indication of the fault to an HMI (122) in a vehicle cab.

8. The computer system of any of claims 1-7, wherein the processing circuitry is further configured to:
disconnect the faulty electrical energy storage pack from a voltage bus.

9. A vehicle (101) comprising the computer system of any of claims 1-8.

10. A computer system comprising processing circuitry configured to:
acquire internal resistance values (R_{cell}) of individual electrical energy storage cells within electrical energy storage packs in a fleet (105) of units,
acquire an overall internal resistance (Rₒᵥₑᵣₐₗₗ) of the electrical energy storage packs in the fleet,
associate each internal resistance value of individual cells and the overall internal resistance with other electrical energy storage pack characteristics (210),
process the acquired internal resistance values and the acquired overall internal resistance values to determine a cell internal resistance reference parameter (212) and an overall internal resistance reference parameter (214) that reflect the typical internal resistance parameter values for a functional electrical energy storage pack of each of the other electrical energy storage pack characteristics (210),
store the cell internal resistance reference parameter and an overall internal resistance reference parameter along with their associated electrical energy storage pack characteristics on a memory storage device (208),
receive a request (C) for cell internal resistance reference parameter and an overall internal resistance reference parameter from a first unit of the fleet, the request including at least one electrical energy storage pack characteristic,
provide, to the first unit (101), reference data associated with the at least one electrical energy storage pack characteristic.

11. A computer-implemented method, comprising:
acquiring (S102), by processing circuitry of a computer system, internal resistance values of individual electrical energy storage cells within an electrical energy storage pack,
acquiring (S104), by the processing circuitry, an overall internal resistance of the electrical energy storage pack including cell and power path resistances,
associating (S106), by the processing circuitry, each internal resistance value of individual cells and the overall internal resistance with other electrical energy storage pack characteristics,
comparing (S108), by the processing circuitry, the internal resistance values of individual cells and the overall internal resistance with a cell internal resistance reference parameter and an overall internal resistance reference parameter for other electrical energy storage packs with similar electrical energy storage pack characteristics, the other electrical energy storage packs are within a fleet of units equipped with the electrical energy storage packs,
when either the acquired internal resistance value of a cell fulfil a cell resistance criterion, and/or the acquired overall internal resistance fulfil an overall resistance criterion, providing (S110), by the processing circuitry, an output message that a fault is detected in the respective cell and/or electrical energy storage pack power path.

12. The method of claim 11, wherein the cell internal resistance reference parameter and the overall internal resistance reference parameter are derived from reference cell internal resistance data and reference overall internal resistance data that are stored in a database comprising reference data for multiple electrical energy storage packs within a fleet of devices or vehicles using the electrical energy storage packs.

13. The method of claim 12, further comprising:
uploading (S114), by the processing circuitry, the acquired internal resistance values to the database for use as future reference data.

14. A computer program product comprising program code for performing, when executed by the processing circuitry, the method of any of claims 11-13.

15. A non-transitory computer-readable storage medium comprising instructions, which when executed by the processing circuitry, cause the processing circuitry to perform the method of any of claims 11-13.
